(19) **Europäisches Patentamt**
**European Patent Office**
**Office européen des brevets**

(11) **EP 4 123 671 A1**

(12) **EUROPEAN PATENT APPLICATION**

(43) Date of publication:
**25.01.2023 Bulletin 2023/04**

(21) Application number: **22183080.5**

(22) Date of filing: **05.07.2022**

(51) International Patent Classification (IPC):
**H01F 19/00** (2006.01)     **H01F 27/36** (2006.01)
**H01F 38/14** (2006.01)     **H05K 9/00** (2006.01)

(52) Cooperative Patent Classification (CPC):
**H05K 9/0018; H01F 19/06; H01F 19/08;**
**H01F 27/2895; H01F 27/363; H05K 9/009**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **23.07.2021 KR 20210096783**

(71) Applicant: **Shin, Gunil**
**Uiwang-si 16009 (KR)**

(72) Inventor: **Shin, Gunil**
**Uiwang-si 16009 (KR)**

(74) Representative: **Beck & Rössig**
**European Patent Attorneys**
**Cuvilliésstraße 14**
**81679 München (DE)**

(54) **ELECTROMAGNETIC WAVE SHIELDING FILTER**

(57)     An electromagnetic wave shielding filter is configured in a magnetic field transmission scheme, not in a low pass filter or band pass filter scheme, and thus allows a desired signal to pass, while maintaining unintended electromagnetic waves shielded. The present embodiment relates to an electromagnetic wave shielding filter for high-frequency communication, having a structure in which an elliptical ferrite magnetic core is formed inside the filter, a primary coil and a secondary coil are installed at both ends of the magnetic core, and then a shielding and penetration unit is formed of a shielding material on the elliptical magnetic field core, so that a signal from the primary coil is transmitted in the form of a magnetic field to the secondary coil, and the other unintended common-mode components are eliminated.

【Fig. 1】

**Description**

CROSS-REFERENCE TO RELATED APPLICATION(S)

This application is based on and claims priority under 35 U.S.C. §119 to Korean Patent Application No. 10-2021-- 0096783 filed on July 23, 2021, in the Korean Intellectual Property Office, the disclosure of which is incorporated by reference herein in its entirety.

BACKGROUND

1. Field

An embodiment of the disclosure relates to an electromagnetic wave shielding filter, and more particularly, to a filter that passes a desirable high-frequency signal into an electromagnetic wave shielding facility, while blocking other interference frequency components.

2. Description of Related Art

The following description is presented as background information only to assist with an understanding of the disclosure. No determination has been made, and no assertion is made, as to whether any of the following might be applicable as prior art with regard to the disclosure.

In general, to verify the shielding performance of an electromagnetic wave shielding facility, a shielding test is conducted according to standards such as IEEE-std-299 or MIL-STD-188-125-1/2, and National Radio Research Agency Notice No. 2016-10.

The electromagnetic wave shielding facility is a facility designed such that the inside is basically separated from the outside in terms of electromagnetic waves, and a server or communication equipment inside the facility is not affected by an external electromagnetic wave environment. The inside and outside of the electromagnetic wave shielding facility communicate with each other by means of an electromagnetic wave shielding filter for internal power supply or communication.

For an existing general electromagnetic wave shielding filter in use, a low pass filter is generally used to block an intended high frequency band from 10kHz to 100kHz to several to 18GHz for electromagnetic wave shielding, and pass a low frequency of 60Hz, for example, for power supply. In some cases, a band pass filter is used to pass only a specific band. A signal in a communication frequency (e.g., 500MHz) higher than the shielding frequency of the low pass filter is converted to an electrical signal, input through an optical cable, and then converted again to an optical signal, for signal transmission, while electromagnetic waves are kept shielded. In this manner, the inside and outside of the electromagnetic wave shielding facility communicate with each other.

In general, a low pass filter-type electromagnetic shielding filter used as a military electromagnetic pulse (EMP) shielding filter that shields electromagnetic waves even in the lowest frequency has a shielding frequency of around 10kHz with a 3dB loss. Because further lowering the shielding frequency causes loss of supplied power, the shielding frequency of 10KHz is usually the lower limit. Accordingly, when a signal is transmitted at or below 10kHz, a lower frequency than 10kHz may pass through the filter, thereby restricting the role of the filter. As such, the current low pass filter-type electromagnetic wave shielding filter has limitations in its effectiveness in blocking all frequency bands, while passing only signals in a desired frequency band. In this context, a fundamental structural change is required in configuring an electromagnetic wave shielding filter.

SUMMARY

Provided is an electromagnetic wave shielding filter based on low pass filtering or band pass filtering, which transmits a desired high frequency signal, while blocking unintended common-mode electromagnetic waves, by disposing an elliptical magnetic core formed of a material with a high magnetic permeability at a part that determines the outside and inside of an electromagnetic wave shielding surface of the filter inside the filter, converting a high frequency electromagnetic wave signal to a differential-mode signal at a primary coil through a core shielding and penetration unit having an appropriate depth and diameter for shielding electromagnetic waves, transmitting the signal in the form of a differential-mode magnetic field from the outside of a shielding facility to the inside of the shielding facility by the elliptical magnetic core, and restoring the differential-mode high frequency signal at a secondary coil.

Additional aspects will be set forth in part in the description which follows and, in part, will be apparent from the description, or may be learned by practice of the presented embodiments of the disclosure.

According to an aspect of the present embodiment, an electromagnetic wave shielding filter installed on one shielding wall of an electromagnetic wave shielding facility includes a primary coil and a secondary coil disposed to oppose each other symmetrically with respect to an elliptical (circular) magnetic core structure with a high magnetic permeability, in which the primary coil and the secondary coil are wound around both short sides thereof, and a high-conductivity (low-resistance) material is formed at the center thereof in a depth and a diameter which enable electromagnetic wave shielding along a longitudinal direction inside the electromagnetic wave shielding filter; an outer enclosure including the magnetic core (magnetic path) with the high magnetic permeability; and a structure filled with a high electrical-conductivity (low-resistance) material along the longitudinal direction at the center of the core.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a diagram illustrating an electromagnetic wave shielding filter including an elliptical (circular) magnetic core and a magnetic core shielding and penetration unit according to the present embodiment;
FIG. 2 is a diagram illustrating an example of applying the electromagnetic wave shielding filter including the elliptical magnetic core and the magnetic core shielding and penetration unit according to the disclosure to an electromagnetic wave shielding facility;
FIG. 3 is a diagram illustrating a longitudinal cross-section and a latitudinal cross-section of the electromagnetic wave shielding filter including the elliptical magnetic core according to the present embodiment;
FIG. 4 is a diagram illustrating an electromagnetic wave shielding filter including double elliptical magnetic cores and primary and secondary coil sets to simultaneously transmit and receive high-frequency signals according to the present embodiment;
FIG. 5 is a diagram illustrating an example of applying an electromagnetic wave shielding filter including a magnetic core shielding and penetration unit, in which a primary loop antenna and a secondary loop antenna are configured using a coaxial cable, instead of a primary coil and a secondary coil according to the present embodiment;

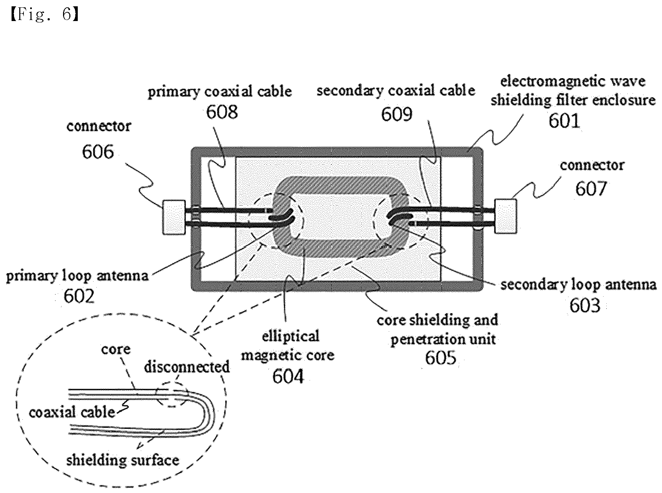

FIG. 6 is a diagram illustrating a filter using a coaxial cable as illustrated in FIG. 5 according to the present embodiment, in which the core of an input coaxial cable is not connected to the ground to allow a differential-mode high-frequency signal to pass, and a part of an external ground of the coaxial cable is cut to serve as an antenna for forming a magnetic field, while maintaining electromagnetic wave shielding, and to effectively dissipate the magnetic field by the configured primary and secondary loop antennas;
FIG. 7 is a diagram illustrating an electromagnetic wave shielding filter using a coaxial cable, for allowing a GHz-band signal to pass according to the present embodiment, in which large surfaces of small loop antennas in the coaxial structure come into contact with each other by removing a ferrite core and applying an air core to allow a GHz-band radio frequency (RF) signal to pass;
FIG. 8 is a diagram illustrating the shape of a honeycomb used for air exhaust of an electromagnetic wave shielding facility; and
FIG. 9 is a diagram illustrating a general low pass filter-type electromagnetic wave shielding filter.

DETAILED DESCRIPTION

An embodiment of the disclosure will be described in detail with reference to the accompanying drawings.

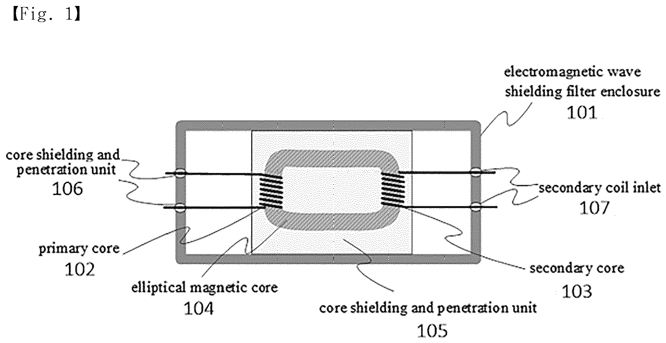

FIG. 1 is a diagram illustrating an electromagnetic wave shielding filter including an elliptical magnetic core according to the present embodiment.
An electromagnetic wave shielding filter including an elliptical (circular) magnetic core according to the present embodiment includes an electromagnetic wave shielding enclosure 101, an elliptical (circular) magnetic core 104, a primary coil 102, a secondary coil 103, and a magnetic core shielding and penetration unit 105, to which the electromagnetic wave shielding filter is not necessarily limited.
As illustrated in FIG. 1, when the electromagnetic wave shielding filter including the elliptical magnetic core is installed on one shielding wall of an electromagnetic wave shielding facility, the primary coil 102 and the secondary coil 103 are installed at both ends of the elliptical magnetic core 104. As the elliptical magnetic core 104 is formed of a material with excellent high frequency characteristics and a high magnetic permeability, a magnetic field formed by a desired signal to be transmitted through the primary coil 102 is transferred to the opposite core via the elliptical magnetic core 104 and converted again to a voltage at the secondary coil 103. The opposite case from the secondary coil 103 to the primary coil 102 is also possible.
When a signal for communication is applied to the primary coil 102, the signal is changed into a magnetic field and induced and transmitted to the secondary coil via the elliptical magnetic core 104. The magnetic field transferred to the secondary coil may be converted into a voltage by the secondary coil, thereby restoring the received signal. In this state, however, the electromagnetic wave shielding filter is simply a transformer with no electromagnetic wave shielding function. When the inner walls of the shielding filter are filled with a material 105 with high electrical conductivity (low resistance) around the elliptical magnetic core 104, a tunnel-shaped structure surrounding the magnetic core 104 is formed, satisfying a condition for electromagnetic wave shielding.

Further, since the physical durability of an elliptical ferrite tile is weak, use of a material such as iron wool or copper wool may facilitate manufacture of the shielding and penetration unit for the elliptical magnetic core, and lead to a significant protective effect against external impact. When the filter enclosure and the core are filled with a high-density metal, external shock is transferred as it is. In contrast, when the filter enclosure and the core are filled with a low-density material such as iron wool or copper wool, a physical impact may be absorbed by the low-density (sponge-like structure) material, and thus its transmission is limited.

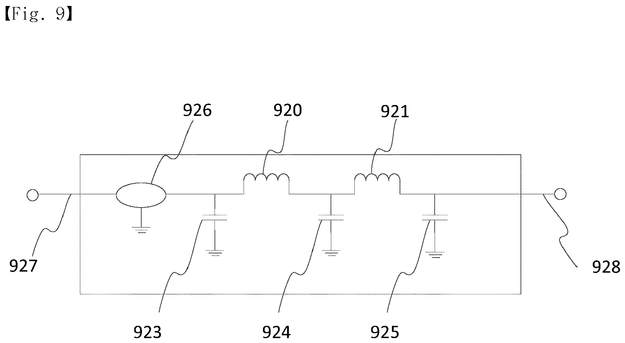

A low pass filter-type electromagnetic wave shielding filter illustrated in FIG. 9 includes inductors 920 and 921, capacitors 923, 924, and 925, and an arrestor 927. Because the electromagnetic wave shielding filter has a structure that passes a frequency equal to or lower than a shielding frequency and a frequency equal to higher than the shielding frequency, it is difficult to pass a high frequency higher than the shielding frequency of the low pass filter into the shielding facility, and thus the electromagnetic wave shielding filter may be applied based on band pass filtering to pass only a specific band. However, since frequency shielding characteristics in the vicinity of the pass band of the band pass filter have a band stop attenuation of about 60dB, it is difficult to secure perfect blocking characteristics. Moreover, when a high-output electromagnetic pulse (EMP) signal is input in the band of the band pass filter, the electromagnetic wave shielding filter may not function to shield electromagnetic waves.

In contrast, the electromagnetic wave shielding filter (FIG. 1) according to the present embodiment transmits a high-frequency signal induced in the elliptical magnetic core 104 only in a differential-mode structure according to an electromagnetic induction law in Maxwell equations (Equation 1). Therefore, common-mode electromagnetic waves that are radiated, such as high-output electromagnetic waves or external electromagnetic wave noise may not pass through the elliptical magnetic core 104 at the primary coil 102 and transmitted to the secondary coil 103.

[Equation 1]

$$\oint_C \mathbf{E} \cdot d\mathbf{l} = -\frac{d}{dt} \int_S \mathbf{B} \cdot d\mathbf{A}$$

In addition, the diameter of the elliptical magnetic core applied in the present embodiment is about 3 to 10mm. Therefore, when a high-output electromagnetic wave of a certain value or higher is input, the magnetic flux of the elliptical magnetic core 104 is saturated, and thus energy at or above a certain level may not be transmitted to the secondary coil. Accordingly, a receiving end and a transmitting end of communication equipment connected to a secondary output of the elliptical magnetic core may be protected.

In addition, despite the fact that the components of the electromagnetic wave shielding filter are high-frequency devices, they are all passive devices and thus have a low possibility of damage. This is because the components do not include a material that is oxidized or chemically changed over time.

Moreover, elements included in the low pass filter (FIG. 9), particularly the arrestor 927 and the capacitors 926, 920, and 921 have limited lifetimes and thus may not be used permanently. These elements are components requiring replacement periodically or when damaged. However, the use of the electromagnetic wave shielding filter (FIG. 1) according to the present embodiment obviates the need for the components, which enables continuous use of equipment inside the shielding facility and almost prevents impact-caused breakage of the ferrite core 104 or overcurrent-incurred damage to the primary coil 102 and the secondary coil 103. Accordingly, the electromagnetic wave shielding filter according to the present embodiment may have a permanent lifetime.

The elliptical magnetic core 104 applied to the electromagnetic wave shielding filter according to the present embodiment may be formed of a ferrite material with good high frequency characteristics and high magnetic permeability. A ZnMn-type ferrite may be used in a relatively low frequency band due to its high conductivity (several tens of ohms), whereas an NiMn-type ferrite may be more effective in a higher frequency band due to its low electrical conductivity (several tens of M ohms) and high magnetic permeability.

Additionally, although the electromagnetic wave shielding filter described in this example is designed as an electromagnetic wave shielding filter for high-frequency signals, it may also be used as an electromagnetic wave shielding filter for a 50Hz or 60Hz power line by applying a stacked iron core instead of the ferrite core. In view of the elliptical magnetic core structure, the primary coil and the secondary coil are far from each other, thereby lowering transmission efficiency. Nonetheless, the electromagnetic wave shielding filter is applicable when needed, because it may secure electromagnetic wave shielding characteristics.

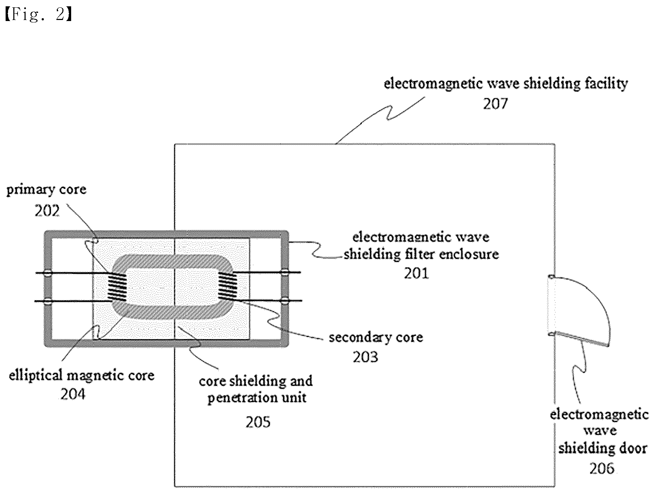

It is difficult to shield electromagnetic waves with the electromagnetic wave shielding filter illustrated in FIG. 2 alone. With an enclosure 201 in close contact with a wall or the ceiling of a shielding facility 207, the electromagnetic wave shielding filter may be used in the shielding facility with all sides of its cubic structure blocked. All of current shielding facilities are built in this structure, and the electromagnetic wave shielding filter is applied to these facilities.

When a hole is formed in the elliptical (circular)magnetic core shielding and penetration unit, and a ZnMn-type ferrite is used for the elliptical magnetic core, the electrical conductivity of the ferrite tile is high (with a low resistance of several tens of ohms), which maintains a blocked shape in terms of electromagnetic waves in spite of the existence of the magnetic core hole. When a NiMn-type ferrite is applied to the elliptical magnetic core, the hole through which the magnetic core passes may be regarded as a structure that impairs electromagnetic wave shielding from the perspective of electromagnetic waves. However, this problem may be overcome by adjusting a hole diameter d 306 and a hole depth g 307 as illustrated in Table 1. Further, because the ferrite material itself has a function of absorbing electromagnetic waves, the ferrite does not affect much in terms of the presence or absence of electromagnetic wave shielding damage.

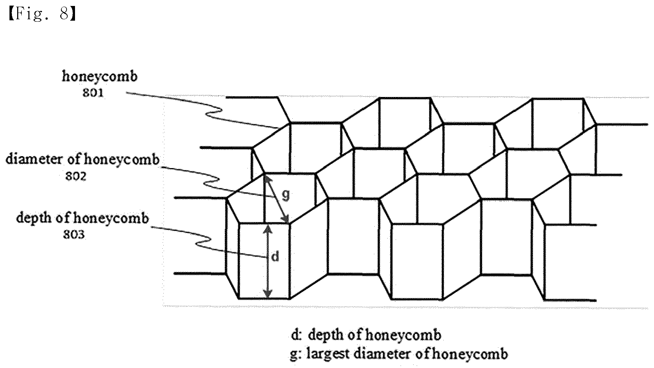

FIG. 8 is diagram illustrating a honeycomb used in a ventilator of an electromagnetic wave shielding facility. The honeycomb is a component that allows air to pass, while shielding electromagnetic waves. Although there is a physical hole (FIG. 8), electromagnetic waves may be shielded within the shielding frequency of the honeycomb.

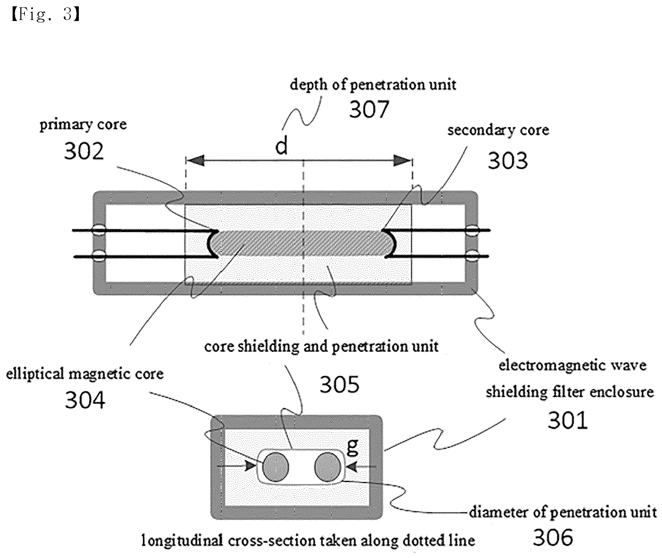

The following table lists formulas for calculating an electromagnetic wave shielding effect determined by the diameter and depth of a honeycomb in an electromagnetic shielding facility. It may be noted that although different electromagnetic shielding effects may be achieved depending on whether the shape of the physical through hole is square, circle, or cube, electromagnetic wave shielding is basically possible at or below the shielding frequency by adjusting the diameter d and depth g of the through hole (see FIGS. 3 and 8) despite the presence of the hole that may impair electromagnetic wave shielding.

[Table 1]

| | $SE_{dB}$ | $SE_{dB}(fc/f > 3)$ |
|---|---|---|
| square | $SE_{dB} = 27.3 \frac{d}{g} \sqrt{1 - \left(\frac{gf}{150000}\right)^2}$ | $SE_{dB} = 27.3 \frac{d}{g}$ |
| circle | $SE_{dB} = 31.95 \frac{d}{g} \sqrt{1 - \left(\frac{gf}{175800}\right)^2}$ | $SE_{dB} = 31.95 \frac{d}{g}$ |
| hexagon | $SE_{dB} = 17.5 \frac{d}{g} \sqrt{1 - \left(\frac{gf}{96659}\right)^2}$ | $SE_{dB} = 17.5 \frac{d}{g}$ |

For example, the shielding effect is maintained at 96dB at 18GHz in a hexagonal honeycomb with a depth d of 20mm and a largest diameter of 3mm. Therefore, even when there is a hole, electromagnetic wave shielding is possible at or below a shielding frequency determined by the depth and diameter of the hole.

Accordingly, even when the NiMn-type ferrite is applied, electromagnetic waves may be kept shielded despite the presence of a hole in terms of electromagnetic waves because the ferrite has a low electrical conductivity (with a high resistance).

The electromagnetic wave shielding filter (FIG. 1) according to the present embodiment does not need a capacitive element (capacitor) and an inductive element (inductor) required for the configuration of the existing low pass filter or band pass filter, and particularly, an arrestor or an EMP protector 926 which is a protection device against an external strong impulsive shock. The elements inside the electromagnetic wave shielding filter (FIG. 9) have limited lifetimes and thus require periodic replacement, resulting in time and cost loss. Compared to the low pass filter, the magnetic field transmission filter advantageously has a high electromagnetic wave shielding effect of 100dB or more across the entire frequency band. What is better, the magnetic field transmission filter has no separate pass band of the electromagnetic wave shielding filter, and maintains electromagnetic shielding even in the pass band through which a signal passes. In addition, since the part surrounding the primary coil, the secondary coil, and the elliptical core forms an electrically short-circuited and shielding structure inside this structure, the phenomenon of electric field emission or coupling is minimized, thereby maintaining electromagnetic wave shielding between the primary and secondary coils.

FIG. 3 is a diagram illustrating a longitudinal cross-section and a latitudinal cross-section of the electromagnetic wave shielding filter including the elliptical (circular) magnetic core according to the present embodiment. In FIG. 3, the diameter and depth of the magnetic core through hole are marked.

The electromagnetic wave shielding filter (FIG. 3) including an elliptical (circular) magnetic core 304 according to the present embodiment includes the elliptical magnetic core 304, a primary coil 302, a secondary coil 303, a magnetic core shielding and penetration unit 305, and an outer enclosure 301. The components of the electromagnetic wave shielding filter (FIG. 3) are not necessarily limited to the above components.

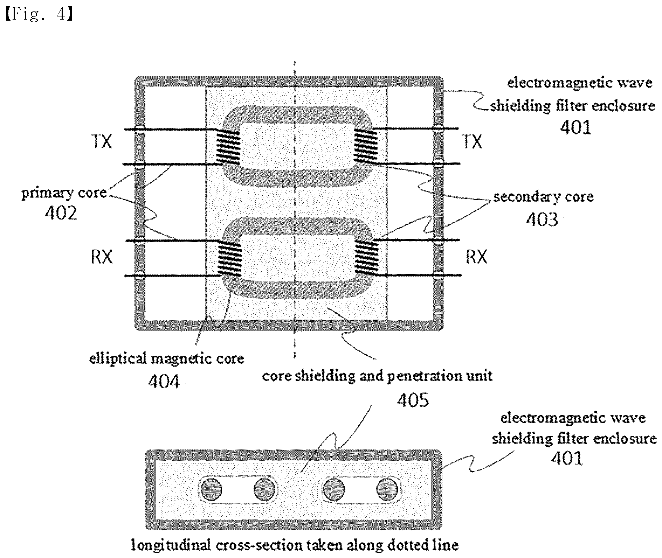

FIG. 4 is a diagram illustrating an electromagnetic wave shielding filter including double elliptical (circular) magnetic cores according to the present embodiment.

The electromagnetic wave shielding filter (FIG. 4) including an elliptical core according to the present embodiment includes two elliptical magnetic cores, two primary coils 402, three secondary coils 403, and a magnetic core shielding and penetration unit 405. To transmit a high frequency signal into a shielding facility in digital communication such as Ethernet signals, the electromagnetic wave shielding filter includes a transmitter and a receiver which are configured individually, for simultaneous transmission and reception. The components of the electromagnetic wave shielding filter (FIG. 4) are not necessarily limited to the above components.

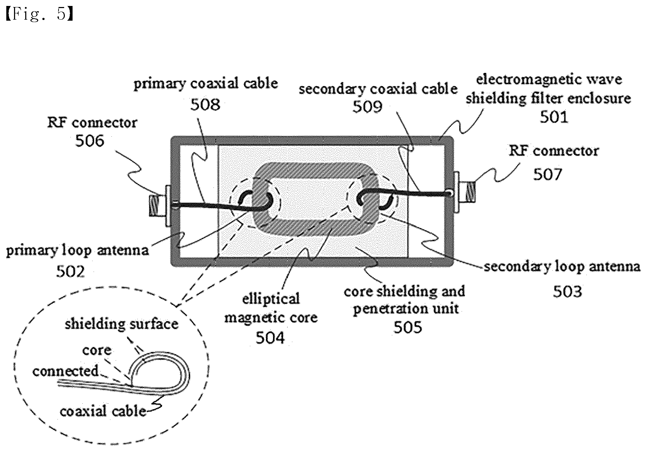

FIG. 5 is a diagram illustrating an electromagnetic wave shielding filter including an elliptical (circular) magnetic core according to the present embodiment.

The electromagnetic wave shielding filter (FIG. 5) including an elliptical (circular) core according to the present embodiment includes an elliptical (circular) magnetic core 504, a loop antenna 502 at the end of a coaxial cable 508, serving as a primary coil, a loop antenna 503 at an end of a coaxial cable 509, serving as a secondary coil, and a magnetic core shielding and penetration part 505. Despite deteriorated transmission characteristics at a low frequency, transmission efficiency may be expected in a higher frequency band than a coil. The loop antennas 502 and 503 may be formed by winding the coaxial cables 508 and 509 around the magnetic core and electrically connecting the cores of the coaxial cables 508 and 509 to the shielding surfaces of the coaxial cables 508 and 509, and thus may play the same role as the primary and secondary coils. Further, since a handled frequency has a bandwidth of several hundreds of MHz to several GHz, SMA- or N-type RF connectors 506 and 507 and the cables 508 and 509 are applied and connected to the loop antennas 502 and 503. Components included in the electromagnetic wave shielding filter (FIG. 5) are not necessarily limited thereto.

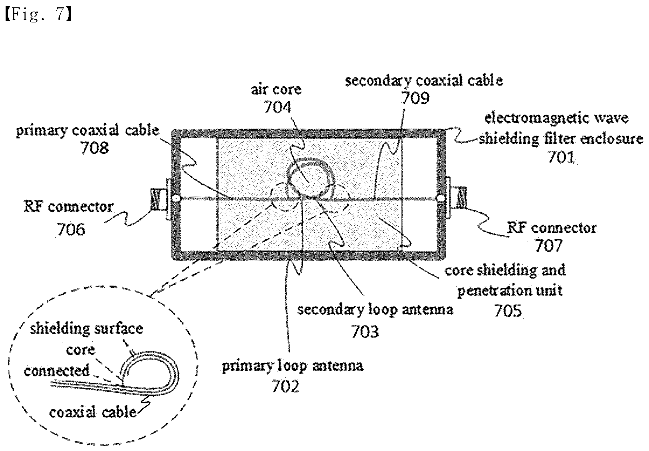

FIG. 7 is a diagram illustrating a case in which a ferrite core is replaced with an air core among the aforementioned characteristics. Because the ferrite material is easy to operate in a frequency band at or below 1GHz but it is difficult to satisfy the magnetic field transfer characteristics at or above 1 GHz, the magnetic core is replaced with the air core. In this case, characteristics of a much higher frequency such as a GHz band may be obtained. This structure may be used to shield electromagnetic waves across a total frequency band, while allowing a signal in a specific GHz band to pass. External electromagnetic waves may be shielded even in an RF pass band, and common-mode external electromagnetic noise being radiated electromagnetic waves may not be transmitted from the primary side to the secondary side in view of the magnetic field transfer structure as described in Equation 1. The primary coaxial cable 708 and the secondary coaxial cable 709 connected to the connectors 706 and 707 outside an electromagnetic wave shielding filter enclosure 701 are configured as a small loop antenna structure in which the cores and outer ground parts of the coaxial cables contact each other in the middle of the cables. The primary loop antenna 702 and the secondary loop antenna 703 are arranged to face each other without being electrically short-circuited to each other, and an input RF signal is transmitted in the form of a magnetic field generated through the primary loop antenna 702 and transferred to the secondary loop antenna 703. A core shielding part surrounding the primary and secondary loop antennas, and a small loop antenna part are electrically separated from each other. In addition, since the loop antennas are short-circuited in terms of an electric field in this space, the electric field may not be radiated, and there is no coupling. Accordingly, a primary end and a secondary end that determine the inside and outside of a shielding room are electrically short-circuited, and thus completely separated from each other across the total frequency band. However, although electromagnetic wave loss may partially occur to the primary side and the secondary side, in the form of a magnetic field only in a specific frequency band responsive to the primary loop antenna 702 and the secondary loop antenna 703, the primary end and the secondary end are connected (within 3dB).

FIG. 8 is a simplified diagram illustrating the shapes of honeycombs installed in a ventilator of the electromagnetic shielding facility. In FIG. 8, a diameter g 802 and a depth d 803 of a hole are shown. FIG. 8 is intended to illustrate that an electromagnetic wave shielding effect is determined by a function of the two terms, and electromagnetic waves are shielded at or below a specific shielding frequency even when there is an electromagnetic hole.

FIG. 9 is a diagram illustrating a general low pass filter-type electromagnetic wave shielding filter for a high-frequency signal line in current use. The electromagnetic wave shielding filter includes inductors 920 and 921, capacitors 923, 924, and 925, and a surge protector 925. A signal input to a filter input end passes only at or below a specific shielding frequency, while being blocked above specific shielding frequency. Although the low pass filter-type electromagnetic wave shielding filter is used in combination with a band pass filter or a high pass filter, when an interference signal or a high-output signal is input into the pass band of the shielding filter, the signal is transmitted to the output through the shielding filter, thereby increasing a possibility of damaging equipment in the shielding facility.

The above description is merely illustrative of the technical idea of the present embodiment, and those skilled in the art will understand that various modifications and variations can be made without departing from the essential features of the present embodiment. Accordingly, the present embodiments are intended to describe rather than limit the technical spirit of the present embodiment, and the scope of the present embodiment is not limited by these embodiments. The protection scope of the present embodiment should be interpreted by the following claims, and all technical ideas within the scope equivalent thereto should be interpreted as being included in the scope of the present embodiment.

As is apparent from the foregoing description, according to the present embodiment, a magnetic path is made of a material having high magnetic permeability on an electromagnetic wave shielding interface that determines the outside and the inside of a filter, so that a high-frequency electromagnetic wave signal in an RF or differential mode is transferred in the form of a magnetic field from the outside to the inside via an elliptical (or circular) magnetic core, and an electromagnetic shielding structure is formed by filling a material having a high conductively (low resistance) around the elliptical magnetic core and the inner surface of a shielding filter enclosure, for shielding an electrical filed and a magnetic field inside and outside an electromagnetic wave shielding facility. Therefore, the filer allows high-frequency radio signals to pass, while shielding the other radiated common-mode electromagnetic waves across a total frequency band.

Further, although a high-frequency signal itself has a differential mode structure and thus passes, high-output electromagnetic waves such as external noise are in a common mode and it is impossible for the high-output electromagnetic waves to pass through the elliptical magnetic core. Accordingly, noise except for a desired signal is blocked across the total band. This is a distinctive feature that differentiates the electromagnetic wave shielding effect from the existing band pass filter-type or low pass filter-type electromagnetic wave shielding filter.

**Claims**

1.  An electromagnetic wave shielding filter comprising:

    an elliptical (circular) ferrite magnetic core (104) installed at the center of the electromagnetic wave shielding filter;
    a primary coil and a secondary coil (102, 103) disposed to oppose each other symmetrically with respect to the elliptical ferrite magnetic core (104), and wound around the elliptical (circular) magnetic core (104);
    a core shielding and penetration unit (105) surrounding the elliptical magnetic core (104); and
    an electromagnetic wave shielding filter outer enclosure surrounding the primary coil, the secondary coil (102, 103), the elliptical ferrite magnetic core (104), and the magnetic core in surface contact, and containing the core shielding and penetration unit in close contact with an inner surface of the shielding filter.

2.  The electromagnetic wave shielding filter according to claim 1, wherein a signal transmission is maintained in the form of a magnetic field by applying a core having good high frequency characteristics and a high magnetic permeability through the elliptical magnetic core (104) to, and electromagnetic shielding between the primary coil and the secondary coil (102, 103) is maintained by electromagnetically shielding around the elliptical magnetic core (104), using the core shielding and penetration unit.

3.  The electromagnetic wave shielding filter according to claim 1 or 2, wherein an elliptical (circular) ferrite core (104) is applied as the magnetic core.

4.  The electromagnetic wave shielding filter according to one of claims 1 to 3, wherein the core shielding and penetration unit (105) grounded and shielded by an inner wall and surface of the electromagnetic wave shielding filter around the center of the elliptical magnetic core is formed of a high conductivity (low resistance) material including iron, copper, or aluminum.

5.  The electromagnetic wave shielding filter according to one of claims 1 to 4, wherein the core shielding and penetration unit is formed of a low-density, high-conductivity material including iron wool or copper wool being a high conductivity (low resistance) material.

6.  The electromagnetic wave shielding filter according to one of claims 1 to 5, wherein the primary coil and the secondary coil (102, 103) are wound around the elliptical (circular) magnetic core (104) once or more times to enable transmission of a radio frequency (RF) signal from a primary end to a secondary end.

7.  The electromagnetic wave shielding filter according to one of claims 1 to 6, wherein instead of the primary coil and the secondary coil (102, 103), coaxial cables (508, 509) are wound around the elliptical (circular) magnetic core (104; 504)) once or more times to enable transmission of an RF signal from a primary end to a secondary end.

8. The electromagnetic wave shielding filter according to one of claims 1 to 7, wherein the elliptical (circular) core (104) is replaced with an air core, and coaxial cables (708, 709) are wound once or more times, instead of the primary coil and the secondary coil (102, 103), to apply loop antennas (702, 703) at ends thereof with surfaces of the loop antennas facing each other and enable transmission of an RF signal from a primary end to a secondary end.

9. The electromagnetic wave shielding filter according to one of claims 1 to 8, wherein the magnetic core is in a structure in which an elliptical (circular) stacked iron core is applied.

【Fig. 1】

electromagnetic wave
shielding filter enclosure
101

core shielding and
penetration unit
106

secondary coil inlet
107

primary core
102

elliptical magnetic core
104

secondary core
103

core shielding and penetration unit
105

【Fig. 2】

electromagnetic wave shielding facility
207

primary core
202

electromagnetic wave
shielding filter enclosure
201

secondary core
203

elliptical magnetic core
204

core shielding and
penetration unit
205

electromagnetic
wave
shielding door
206

【Fig. 3】

depth of penetration unit
307

primary core
302

secondary core
303

d

elliptical magnetic core
304

core shielding and penetration unit
305

electromagnetic wave
shielding filter enclosure
301

g

diameter of penetration unit
306

longitudinal cross-section taken along dotted line

【Fig. 4】

electromagnetic wave shielding filter enclosure 401

TX

TX

primary core 402

secondary core 403

RX

RX

elliptical magnetic core 404

core shielding and penetration unit 405

electromagnetic wave shielding filter enclosure 401

longitudinal cross-section taken along dotted line

【Fig. 5】

primary coaxial cable 508

secondary coaxial cable 509

electromagnetic wave shielding filter enclosure 501

RF connector 506

RF connector 507

primary loop antenna 502

secondary loop antenna 503

elliptical magnetic core 504

core shielding and penetration unit 505

shielding surface

core connected

coaxial cable

【Fig. 6】

primary coaxial cable 608

secondary coaxial cable 609

electromagnetic wave shielding filter enclosure 601

connector 606

connector 607

primary loop antenna 602

secondary loop antenna 603

core shielding and penetration unit 605

elliptical magnetic core 604

core

disconnected

coaxial cable

shielding surface

【Fig. 7】

air core
704

secondary coaxial cable
709

primary coaxial cable
708

electromagnetic wave
shielding filter enclosure
701

RF connector
706

RF connector
707

core shielding and
penetration unit
705

secondary loop antenna
703

primary loop antenna
702

shielding surface
core
connected
coaxial cable

【Fig. 8】

honeycomb
801

diameter of honeycomb
802

depth of honeycomb
803

d: depth of honeycomb
g: largest diameter of honeycomb

【Fig. 9】

Europäisches
Patentamt

European
Patent Office

Office européen
des brevets

# EUROPEAN SEARCH REPORT

Application Number

EP 22 18 3080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 310 589 A2 (SPRECHER ENERGIE OESTERREICH [AT]) 5 April 1989 (1989-04-05) | 1-4,6-9 | INV. H01F19/00 H01F27/36 H01F38/14 H05K9/00 |
| A | * column 1, lines 4-47 * * column 5, lines 37-62 * * figure 2 * | 5 | |
| X | US 4 660 014 A (WENAAS ERIC P [US] ET AL) 21 April 1987 (1987-04-21) * the whole document * | 1-4,6-9 | |
| A | JP 2004 080908 A (TOYO ELECTRIC MFG CO LTD) 11 March 2004 (2004-03-11) * paragraph [0014]; figure 3 * | 7,8 | |

TECHNICAL FIELDS
SEARCHED      (IPC)

H01F
H05K

The present search report has been drawn up for all claims

| Place of search | Date of completion of the search | Examiner |
|---|---|---|
| The Hague | 8 December 2022 | Thibaut, Arthur |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 18 3080

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2022

| Patent document cited in search report | | Publication date | Patent family member(s) | | Publication date |
|---|---|---|---|---|---|
| EP 0310589 | A2 | 05-04-1989 | AT | 388260 B | 26-05-1989 |
| | | | EP | 0310589 A2 | 05-04-1989 |
| | | | ES | 2040383 T3 | 16-10-1993 |
| | | | GR | 3008461 T3 | 29-10-1993 |
| US 4660014 | A | 21-04-1987 | NONE | | |
| JP 2004080908 | A | 11-03-2004 | NONE | | |

EPO FORM P0459

For more details about this annex : see Official Journal of the European Patent Office, No. 12/82

**EP 4 123 671 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210096783